# EUROPEAN PATENT SPECIFICATION

(11) **EP 0 378 256 B1**
(45) Date of publication and mention of the grant of the patent: **02.10.1996**
(21) Application number: 90200007.4
(22) Date of filing: 03.01.1990
(51) Int. Cl.: H01L 21/50

(54) **Method of hermetically sealing a container**
Verfahren zum hermetischen Abschliessen eines Behälters
Procédé de fermeture hermétique d'un conteneur

(30) Priority: 09.01.1989 NL 8900042
(43) Date of publication of application: 18.07.1990
(73) Proprietor: Philips Electronics N.V., 5621 BA Eindhoven (NL)
(72) Inventor: Maan, Nicolaus, NL-5656 AA Eindhoven (NL)
(74) Representative: Bos, Kornelis Sjoerd

(56) References cited:
- EP-A- 0 066 136
- EP-A- 0 203 589
- PATENT ABSTRACTS OF JAPAN vol. 11, no. 227 (E-526)(2674) 23 July 1987, & JP-A- 62 45049 (ROHM) 27 February 1987,

## Description

The invention relates to a method of hermetically sealing a first container, which first container has at least two parts connected by means of a thermo-setting glue, said method comprising the steps of positioning said first container, with said thermo-setting glue interposed between corresponding surfaces of said at least two parts in a second container, and heating the resultant arrangement of first and second containers to thereby use said thermosetting glue.

The invention more particularly relates to a method of sealing in a moisture- and gas-tight manner sensors, CCD's (Charge-Coupled Devices) and LCD's (Liquid Crystal Displays).

A method of the kind to which the present invention relates is known from EP-A-0 066 136. In this known method two substrates, between which a space (called first space) is present containing a liquid display medium, are bonded to each other in a peripheral region by using a heat-curable adhesive with interposal of a finely divided spacer material. In order to get a uniform pressure on the substrates during the curing process the two substrates are placed in a container having a flexible wall, after which a vacuum applied to the space inside the container surrounding the substrates (called second space) causes the flexible wall to be pressed against the substrate surface. A disadvantage of this method is that during heating to cure the glue the pressure in the first space as well as in the second space rises. However, the second space is connected to the vacuum source which will lower the rised pressure of the second space. The first space will become a higher pressure than the second space, resulting in a movement of gas from the first to the second space. Because of this movement of gases ducts are created in the thermo-setting glue. No hermetically sealing glue connection is then obtained.

Another method is known from JP-A-5343477. In this method, a cavity in a substrate is closed by a covering plate, which is connected across the cavity to the substrate by means of a thermo-setting glue. The covering plate is provided with a hole through which gases can escape from the cavity. This is necessary because during the curing operation a pressure is built up in the closed cavity due to the temperature increase and gases tend to escape from the cavity due to this build-up of pressure. The hole is closed afterwards by means of another glue. If the covering plate should be qlued to the substrate without being provided with a hole, ducts would be formed in the thermo-setting glue connection during the curing operation due to the escape of gases from the cavity. No hermetically sealing glue connection is then obtained.

Another method of the kind to which the present invention relates is known from JP-A-5857879. In this method, a cavity in a substrate is closed by a covering plate which is connected across the cavity to the substrate by means of two kinds of glue. The two glues are provided one beside the other and, after the first glue has cured at room temperature, the second thermo-setting glue is cured at elevated temperature. The gases which tend to escape from the cavity during the curing operation are stopped by the first glue connection and, after the second glue connection has cured, the cavity is sealed hermetically.

A disadvantage of the last two methods described hereinbefore is that additional laborious operations are necessary to obtain a hermetically sealing thermo-setting glue connection.

A hermetically sealing connection cannot be obtained by means of non-thermo-setting glues because these glues are pervious to moisture.

The invention has for its object to provide a method of the kind described hereinbefore, by which a container is sealed hermetically in a simple manner by means of a thermo-setting glue connection. This is achieved by the method according to claim 1.

According to the invention, this object is mainly achieved in that, after positioning said first container in said second container, said second container is hermetically sealed, whereby during said curing an increase in temperature causes an increase in pressure inside and outside the first container, which pressures are substantially equal to each other. As a result, no ducts are formed in the glue connection, while further additional operations, such as the formation of a hole in a covering plate or the use of two glue connections, have become superfluous.

The second container can be constituted by a furnace that can be sealed hermetically. However, a simpler furnace will suffice in an embodiment of the method according to the invention, in which the two containers are arranged in a furnace before the curing operation. Thus, it is possible to establish a good glue connection by means of a simple furnace and a second container that can be readily sealed hermetically. It is also possible to use a "tunnel" furnace. In this case, the second container may be constituted, for example, by a boiler to be sealed hermetically. These measures lead to a reduction of cost.

In another embodiment of the method according to the invention, the boundary surfaces to be interconnected are clamped on each other during curing. As a result, the boundary surfaces are glued accurately on each other and the boundary surfaces cannot be displaced ("swab") with respect to each other during curing.

The glue may be applied in any arbitrary manner, for example by means of a "dispenser" or by means of a die. However, in a further embodiment of the method according to the invention, the thermo-setting glue is applied by means of screen printing to one or more of the boundary surfaces to be interconnected. By this method, the glue can be applied accurately and in a reproducible manner and an aesthetic and reliable glue connection is obtained.

The method according to the invention can be used very advantageously for manufacturing electronic components which mainly consist of a container formed by a support and a covering plate, and a moisture-sensitive element arranged inside the container, the covering plate and the support are interconnected by means of a thermo-setting glue and the container sealed hermetically. By the use of the method described above, it is possible to enclose hermetically the moisture-sensitive element in the container. This hermetic enclosure is necessary because, when the moisture-sensitive element becomes moist, the electronic component becomes unserviceable.

The invention will be described more fully with reference to the drawing. In the drawing:
Figure 1 shows diagrammatically a container enclosed in another container;
Figure 2 shows diagrammatically an embodiment of two containers in a furnace during curing;
Figure 3 shows diagrammatically an embodiment of an electronic component in a chamber;
Figure 4 shows diagrammatically an electronic component manufactured by the method according to the invention;
Figure 5 shows diagrammatically another electronic component manufactured by the method according to the invention.

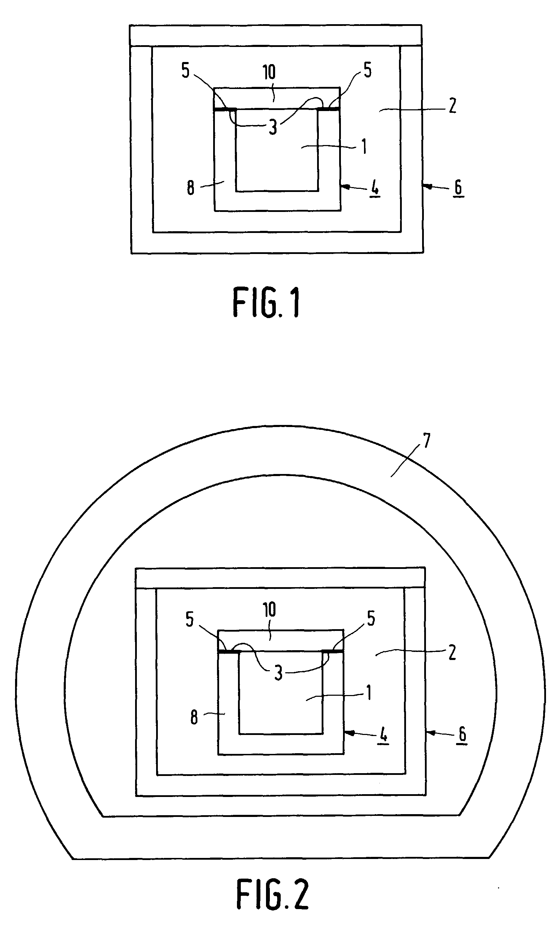

The principle of the method according to the invention will be explained with reference to Figures 1 and 2.

Figure 1 shows diagrammatically a first container 4 and a second container 6. The first container 4 comprises walls 8,10 which surrounds a cavity, called the first space 1. Interconnecting boundary surfaces 3 of the walls 8,10 are hermetically sealed by means of a thermo-setting glue 5. First container 4 is positioned in second container 6. The space inside the second container 6 surrounding the first container 4 is called the second space 2. The operation of curing the thermo-setting glue 5 is carried out in the second space 2. The temperature and the pressure in the second space 2 before curing are equal to the temperature and the pressure in the first space 1. Also during curing, the temperature in both spaces is substantially equal and because both spaces are sealed hermetically, the pressure in both spaces also remains substantially equal.

Figure 2 shows diagrammatically an embodiment of two containers 4,6 arranged in a furnace 7. The temperature in the furnace 7 and in the two spaces 1,2 inside the respective containers is substantially equal during curing. The pressure in the furnace 7 deviates during curing from the pressure in the first and second spaces 1,2. The pressure in these spaces 1,2 remains substantially equal.

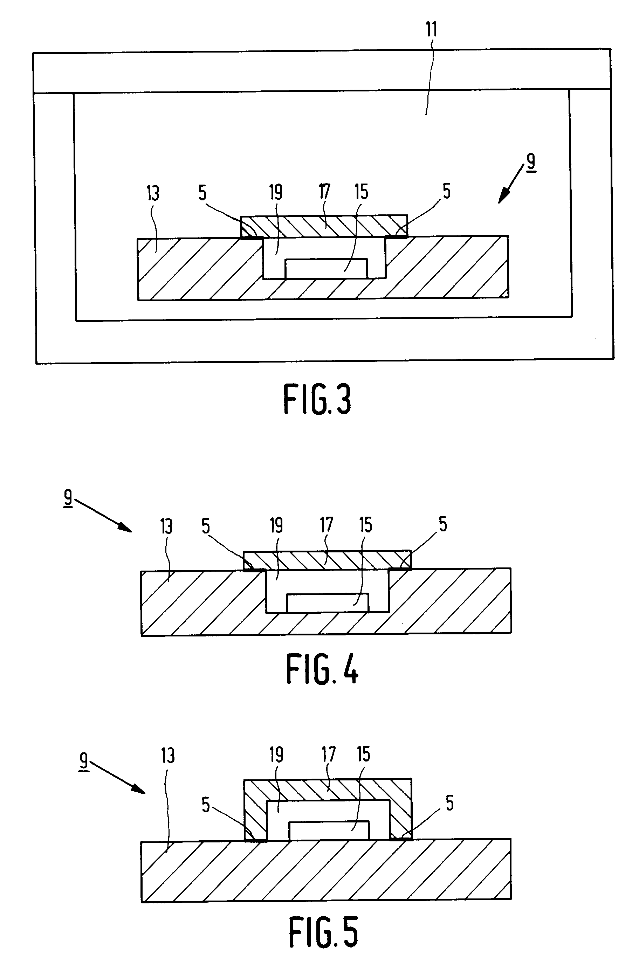

With reference to Figure 3, the manufacture of an electronic component 9 by means of the method according to the invention will be described.

Figure 3 shows diagrammatically an electronic component 9, representing said first container, in a hermetically sealed chamber 11 (second space). The electronic component 9, for example a CCD, consists of a support 13, a moisture-sensitive element 15 and a covering plate 17. The covering plate 17 is secured by means of thermo-setting glue 5 over the moisture-sensitive element 15 on the support 13. Before curing, the temperature and the pressure in the chamber 11 and in a cavity 19 (first space) bounded by the support 13 and by the covering plate 17 are equal. Since the chamber 11 is sealed hermetically, the temperature and the pressure in the chamber 11 and in the cavity 19 are substantially equal also during curing.

Figure 4 shows diagrammatically an electronic component 9 manufactured by the method according to the invention, parts identical to Figure 3 being provided with the same reference numerals. In this embodiment, the cavity 19 is provided in the support 13 and is closed by a flat covering plate 17.

Figure 5 shows diagrammatically another electronic component 9 manufactured by the method according to the invention, parts identical to Figure 3 or 4 being provided with the same reference numerals. In this embodiment, the support 13 is of flat shape, while the covering plate 17 is U-shaped.

## Claims

1. A method of hermetically sealing a first container consisting of at least two parts which are connected by means of a thermo-setting glue, said method comprising the steps of:
i) positioning said first container, with said thermo-setting glue interposed between corresponding connecting surfaces of said at leat two parts in a second container, and
ii) heating the resultant arrangement of first and second containers to thereby cure said thermo-setting glue,
characterised in that,
between positioning step i) and heating step ii) said second container is hermetically sealed, whereby during heating step ii) said thermo-setting glue is subjected to an internal and an external increase of pressure caused by said heating and which pressure increases are substantially equal to each other.

2. A method as claimed in claim 1, characterised in that said resultant arrangement is placed in a furnace prior to the heating step ii).

3. A method as claimed in claim 1 or 2, characterised in that said at least two parts of said first container, with said thermo-setting glue interposed between corresponding connecting surfaces of said at leat two parts are clamped on each other during the heating step ii).

4. A method as claimed in claim 1, 2 or 3, characterised in that said thermo-setting glue is applied to corresponding connecting surfaces of said at least two parts by means of screen printing.

5. A method of manufacturing electronic components mainly consisting of a hermetically sealed first container and a moisture sensitive electronic component arranged inside said first container, characterised in that said moisture sensitive electronic component is hermetically sealed within said first container by the method according to any one of the claims 1-4.

## Patentansprüche

1. Verfahren zum hermetischen Abschließen eines ersten Behälters, der aus zumindest zwei Teilen besteht, die mit Hilfe eines wärmeaushärtenden Klebstoffs verbunden werden, wobei das Verfahren aus den folgenden Schritten besteht:
i) Positionieren des genannten ersten Behälters, wobei der genannte wärmeaushärtende Klebstoff zwischen entsprechenden Verbindungsflächen der genannten zumindest zwei Teile in einem zweiten Behälter liegt, und
ii) Erhitzen der sich ergebenden Anordnung von erstem und zweitem Behälter, um dadurch den genannten wärmeaushärtenden Klebstoff auszuhärten,
dadurch gekennzeichnet, daß
zwischen dem Positionierungsschritt i) und dem Erhitzungsschritt ii) der genannte zweite Behälter hermetisch abgeschlossen wird, wodurch während des Erhitzungsschrittes ii) der genannte wärmeaushärtende Klebstoff einem durch das genannte Erhitzen bewirkten inneren und äußeren Druckanstieg ausgesetzt wird und wobei diese Druckanstiege nahezu einander gleich sind.

2. Verfahren nach Anspruch 1, dadurch gekennzeichnet, daß die genannte sich ergebende Anordnung vor dem Erhitzungsschritt ii) in einen Ofen eingebracht wird.

3. Verfahren nach Anspruch 1 oder 2, dadurch gekennzeichnet, daß die genannten zumindest zwei Teile des genannten ersten Behälters, wobei der genannte wärmeaushärtende Klebstoff zwischen entsprechenden Verbindungsflächen der genannten zumindest zwei Teile gebracht ist, während des Erhitzungsschrittes aufeinander geklemmt werden.

4. Verfahren nach Anspruch 1, 2 oder 3, dadurch gekennzeichnet, daß der genannte wärmeaushärtende Klebstoff mittels Siebdruck auf entsprechende Verbindungsflächen der genannten beiden Teile aufgebracht wird.

5. Verfahren zur Herstellung elektronischer Bauelemente, die hauptsächlich aus einem hermetisch abgeschlossenen ersten Behälter und einem in dem genannten ersten Behälter angeordneten feuchtigkeitsempfindlichen elektronischen Bauelement bestehen, dadurch gekennzeichnet, daß das genannte feuchtigkeitsempfindliche elektronische Bauelement in dem genannten ersten Behälter durch das Verfahren nach einem der Ansprüche 1 bis 4 hermetisch abgeschlossen wird.

## Revendications

1. Procédé pour la ferméture hermétique d'un premier conteneur constitué par au moins deux parties qui sont reliées entre elles à l'aide d'une colle thermodurcissante, ledit procédé comprenant les étapes suivantes:
i) le positionnement dudit premier conteneur, avec de la colle thermodurcissante interposée entre les surfaces de raccordement correspondantes desdites au moins deux parties dans un deuxième conteneur et
ii) le chauffage de l'ensemble résultant des premier et deuxième conteneurs pour durcir ainsi ladite colle thermodurcissante,
caractérisé en ce qu'entre l'étape de positionnement i) et l'étape de chauffage ii), ledit deuxième conteneur est fermé hermétiquement, alors que, lors de l'étape de chauffage ii), ladite colle thermodurcissante est soumise à une augmentation interne et une augmentation externe de la pression provoquées par ledit chauffage, augmentations de pression qui sont pratiquement égales l'une à l'autre.

2. Procédé selon la revendication 1,caractérisé en ce que ledit ensemble résultant est placé dans un four avant l'étape de chauffage ii).

3. Procédé selon la revendication 1 ou 2, caractérisé en ce que lesdites au moins deux parties dudit premier conteneur, avec ladite colle thermodurcissante interposée entre les surfaces de raccordement correspondantes desdites au moins deux parties, sont serrées l'une sur l'autre pendant l'étape de chauffage ii.

4. Procédé selon la revendication 1, 2 ou 3, caractérisé en ce que ladite colle thermodurcissante est appliquée par sérigraphie sur les surfaces de raccordement correspondantes desdites au moins deux parties.

5. Procédé pour la fabrication de composants électroniques constitués essentiellement par un premier conteneur fermé hermétiquement et un composant électronique sensible à l'humidité disposé dans ledit premier conteneur, caractérisé en ce que ledit composant électronique sensible à l'humidité est fermé hermétiquement dans ledit premier conteneur par le procédé selon l'une des revendications 1 à 4.
